# EUROPEAN PATENT SPECIFICATION

(11) **EP 1 838 592 B1**
(45) Date of publication and mention of the grant of the patent: **15.10.2008**
(21) Application number: 05818350.0
(22) Date of filing: 12.12.2005
(51) Int. Cl.: B65D 43/16, B65D 65/46, C09K 3/16, H05K 9/00, B65D 75/36

(54) **ELECTROSTATICALLY DISSIPATIVE PACKAGES AND ARTICLES**
VERPACKUNGEN UND ARTIKEL MIT ELEKTROSTATISCHER AUFLADUNGSMINDERUNG
CONDITIONNEMENTS ET ARTICLES A DISSIPATION ELECTROSTATIQUE

(30) Priority: 10.12.2004 GB 0427130
(43) Date of publication of application: 03.10.2007
(73) Proprietor: Premier Farnell PLC, Armley Road Leeds, LS12 2QQ (GB)
(72) Inventor: EDWARDS, David Brian, Stevenage, Hertfordshire SG2 7HG (GB); DREW, Bruce Michael, Great Dunmow, Essex CM6 1DT (GB); McCARTHY, William John, Shaftesbury, Dorset SP7 0EN (GB)
(74) Representative: Mohun, Stephen John
(86) International application number: PCT/GB2005/004738
(87) International publication number: WO 2006/061634

(56) References cited:
- US-A- 3 959 425
- US-A- 4 746 574
- US-A- 4 820 471

## Description

This invention relates to electrostatically dissipative packages comprising polymeric materials that exhibit the property of dissipating static electricity. The invention is concerned particularly with filmic, moulded or extruded packages comprising such materials that are biodegradable and/or compostable. In addition, the invention relates to other articles, including fabrics, comprising such materials. A prior art example of an electrostatically dissipative package is disclosed in US 4 746 574. Whereas filmic, moulded or extruded materials made from thermo-plastically processable starch (TPS) are both compostable and biodegradable, they offer unsatisfactory performance in all applications where static dissipative properties are required. However, the inventors have discovered that by the addition of polyvinyl alcohol (PVOH) the resulting composition remains both compostable and biodegradable, and yet can be satisfactorily processed by extrusion or by other means to make filmic substrates, blow moulded containers, injection moulded containers and extruded threads or profiles offering valuable static dissipative properties, suitable for subsequent conversion into packages (such as containers or envelopes), footwear, mats and garments for use in, by way of example, clean rooms. It should be noted that the above list of products and applications are by no means limiting.

The present invention is defined in the attached independent claims to which reference should now be made. Further, preferred features may be found in the sub-claims appended thereto.

According to one aspect of the present invention, there is provided an electrostatically dissipative package for containing an article sensitive to static electricity, the package substantially comprising a non-expanded polymeric material which has electrostatic dissipative properties, wherein said polymeric material comprises a mixture of polyvinyl alcohol (PVOH) and thermo-plastically processable starch (TPS). Advantageously, the package is biodegradable and compostable. Furthermore, the package is durable and not frangible.

According to an embodiment of the above aspect, at least a portion of the polymeric material is a film. In addition, the package may be a bag. Preferably, the bag includes a closure mechanism comprising the polymeric material. '

According to a further embodiment, the package is a clam-shell, blister pack or IC tube.

Preferably, the package entirely comprises the non-expanded polymeric material so as to ensure suitable electrostatic dissipative properties of the whole of the package...

Preferably, the material comprises at least 10%, more preferably 25%, of starch by weight. Preferably, the material comprises at least 10% of PVOH by weight. More preferably, the material comprises at least 20% PVOH by weight. Still more preferably, the material comprises at least 25% PVOH by weight. Furthermore, the material may comprise substantially equal quantities of starch and PVOH, or it may comprise up to 75% of either starch or PVOH. It may of course be possible for the material to comprise a higher percentage of either material according to the processing and/or application requirements.

In addition, the package should be sealable. Preferably, the package is sealable so as to completely encapsulate the article being packaged. More preferably, the package includes a closure mechanism to enable it to be sealed. Still more preferably, the closure mechanism comprises the polymeric material having static dissipative properties.

The invention further includes the use of a non-expanded polymeric material to form a package for containing an article sensitive to static electricity, the material including a mixture of thermo-plastically processable starch (TPS) and polyvinyl alcohol (PVOH). The composition of the polymeric material may be the same as any of the compositions outlined above in the embodiments of the electrostatically dissipative package.

The invention also includes a fabric article having electrostatic dissipative properties, comprising fibres of a polymeric material, the material comprising a mixture of thermo-plastically processable starch (TPS) and polyvinyl alcohol (PVOH). The composition of the polymeric material may be the same as any of the compositions outlined above in the embodiments of the electrostatically dissipative package.

The invention also includes an article sensitive to static electricity when packaged in a package according to any statement herein.

The invention may include any combination of the features or limitations referred to herein, except such features as are mutually exclusive.

Products made in accordance with the invention may offer enhanced static dissipative performance as well as being compostable and biodegradable, as defined in European Norm EN 13432.

The table below (Table 1) shows static charge decay data for materials embodying the invention and for materials comprising polyethylene, materials comprising 100% PVOH and materials comprising 100% starch. The table shows the material under test, the run number, the time taken for a charge applied to a surface of the material to decay to 10% of its starting value (charge decay time) and the capacitance loading of the material. The capacitance loading is a ratio of the surface voltage achieved per unit of charge for a thin film of a good dielectric and the surface voltage achieved on the test material per unit of charge with a similar charge distribution.

The references to 'outside' and 'inside' in the table refer to different surfaces of the material under test. It is necessary to test both the outer and inner surfaces of the material because, by way of example, antistatic agents used in prior art materials have a tendency to migrate to the polymer surface.

**Table 1**

| MATERIAL UNDER TEST | Run no. | Charge Decay Time (secs) | Capacitance loading (no units) |
|---|---|---|---|
| Black shielding (EN61340-5) (polyethylene) outside | 411 | 0.62754 | 9209.6 |
| Black shielding (EN61340-5) (polyethylene) inside | 412 | 0.57676 | 3975.25 |
| Starpol 1050 (50% PVOH 50% starch) inside | 418 | 0.67051 | 1737.04 |
| Starpol 1050 (50% PVOH 50% starch) outside | 417 | 0.67051 | 1340.66 |
| Starpol 6050 (50% PVOH 50% starch) outside | 419 | 0.72715 | 1947.42 |
| Starpol 6050 (50% PVOH 50% starch) inside | 420 | 0.68027 | 1475.35 |
| W60 black (100% PVOH) outside | 415 | 0.85996 | 1042.11 |
| W60 black (100% PVOH) inside | 416 | 0.68613 | 835.168 |
| C25 blue (100% PVOH) outside | 421 | 0.65684 | 822.46 |
| C25 blue (100% PVOH) inside | 422 | 0.67441 | 811.925 |
| C10 red (100% PVOH) inside | 424 | 0.68223 | 242.965 |
| C10 red (100% PVOH) outside | 423 | 0.68809 | 217.142 |
| Pink PE (polyethylene) . inside | 410 | 6.0484 | 8.79482 |
| Pink PE (polyethylene) outside | 409 | 2.3648 | 2.11883 |
| Starpol NS (100% starch) inside | 414 | >20 | 1.06895 |
| Starpol NS (100% starch) outside | 413 | >20 | 0.917135 |

It can be seen from the table that the materials embodying the invention have charge decay times similar to those of the 100% PVOH materials and far shorter than those of the 100% starch materials. Furthermore, it can be seen that the materials embodying the invention exhibit high capacitance loading. Hence, it can be seen that the materials embodying the invention have good static dissipative properties.

It is known from the prior art that static dissipation can be improved by increasing the moisture content of the atmosphere, and various means have therefore been employed to improve the static dissipative properties of highly insulating thermoplastic polymers by attracting moisture to the surface of the polymer. This has been done by applying external antistatic coatings by conventional methods or by including internal antistatic agents that are volume-dispersed within the polymer, i.e. incorporated into the polymer by compounding or extrusion prior to or during moulding or film forming. These agents work by migrating to the polymer surface by what is known as a blooming effect, attracting moisture causing enhanced decay of electrostatic charges.

It will be noted that articles of packaging made according to this invention require no antistatic agents, either external or internal, to achieve higher static dissipative performance than is obtained with current conventional articles of packaging, although such antistatic agents can be added if specific enhanced performance levels are needed. Furthermore, the polymeric materials comprised within this invention are in equilibrium with the moisture in the atmosphere and have been found to offer better performance response to changes in relative humidity between 20% and 80% than is the case with current conventional products. Furthermore, because the anti-static characteristic of the polymeric materials comprised within the invention is an inherent characteristic of those materials, the electrostatic dissipative properties of the packages and articles using those materials are more consistent than those of existing packaging materials because of the difficulty in ensuring a uniform distribution of antistatic agents in the existing materials.

Preferably the material from which articles of packaging are made comprises at least 10% but more preferably at least 25% of starch, and at least 10%, preferably at least 20%, and more preferably at least 25% of PVOH (by weight). For example it might comprise equal proportions of starch and PVOH, or up to 75% of one component. The composition may also include a plasticiser. For example, the pellets of starch may contain a plasticiser; and/or the pellets of PVOH may contain a plasticiser.

Although starch and PVOH are chemically unrelated, and are significantly different in their physical properties, it has surprisingly been found that they form a homogeneous film that appears uniform. This may be contrasted with the result of extruding a mixture of PVOH and polyethylene, which produces an inhomogeneous film which is stringy and web-like. The film can be blown to a thickness down to 20 µm without loss of uniformity.

Furthermore the resulting film is considerably more readily biodegradable than PVOH (which does not begin to biodegrade until exposed to an aqueous environment). It also has the advantage of being considerably cheaper than PVOH alone.

Pellets of starch and of PVOH are melt-blended in a single screw extruder to form a homogenous blend, and then extruded. Clearly the pellets may be mixed before being fed into the extruder, or may be fed separately into the extruder and mixed in it. It is consequently very straightforward to adjust the proportions of the two components, PVOH and starch, by merely adjusting the numbers of pellets of each. The term "melt" as used herein includes, but is not limited to, merely softening the polymers sufficiently for extrusion. The melting point of starch is about 120-130°C and that of PVOH is about 180-220°C, depending on grade; the extrusion process preferably is carried out at temperatures in the range about 160° to 185°C (depending on the grade of PVOH), that is to say at temperatures above the melting point of starch but below that of the PVOH.

Blown film extrusion is well known as a process for making plastic bags and plastic sheets. Typically, a tube of molten plastic is extruded from an annular die, and then stretched and expanded to a larger diameter and a reduced radial thickness by internal air pressure and tension from rollers. The hot tube is cooled by ambient air. Ambient air is also used to provide the internal air pressure within the tube, and so to control the size and thickness of the film tube. There may thus be a flow of air over only the external surface, or over both the external and internal surfaces of the tube in order to obtain the required degree of cooling. Careful control of the air pressure within the tube enables the final diameter of the tube to be controlled, as well as the film thickness.

The term "starch" in this specification refers to carbohydrates of natural, vegetable origin, composed mainly of amylose and/or amylopectin. The term should be understood to encompass unmodified starches, physically modified starches, such as thermoplastic, gelatinized or cooked starches, starches with a modified acid value (pH) where acid has been added to lower the acid value of a starch to a pH in the range of from 3 to 6, ungelatinized starches or cross-linked starches. A variety of plants may be used as a source of starch, for example potatoes, wheat, maize or tapioca.

An embodiment of the invention will now be described, by way of example only:

### Example 1

Pellets of starch and PVOH were supplied through chutes of a conventional blown film extrusion apparatus incorporating a hopper. The pellets were typically of diameter in the range 2-3 mm and of length in the range 2-4 mm. The mixture of pellets in the hopper was fed into a single-screw extruder that mixed and heated the polymers, and the resulting molten mixture was supplied to an annular die. It emerged as a polymer tube. Compressed air was fed into the inside of the tube from a duct, so the tube increased in diameter. Typically diameter increases in the range 2.5 to 4.5 times are possible. As the tube cooled, its physical dimensions became set (at what may be referred to as the "frost point"). The tube was then guided by angled guides to a pair of nip rollers which flattened the tube so as to form two flat films; the nip rollers pulled the tube at a faster rate than it was extruded through the die, so the tube was stretched longitudinally (as well as being stretched transversely by the air pressure). The films were then fed onto a storage roller. Apparatus such as was used in this process is known, and for example is described in US 3 959 425 and in US 4 820 471, at least as regards forming films from polyethylene.

Biodegradable, water-soluble or water-dispersible films can thus be made at a relatively low cost, and with good physical properties. This is evident from the measured properties of the resulting films as shown in Table 2, in which measurements made on a conventional PVOH film are compared with those made from a mixture of PVOH and starch containing 50% of each component; in this case the PVOH is a grade which would be soluble in cold water at 10°C. The two films embodying the invention were of nominal thicknesses 25 and 75 µm. The mechanical properties (of dry film) are tabulated in both the machine direction (MD), which is the longitudinal direction of the extrusion, and in the transverse direction (TD). The disintegration and dissolution times are the times taken for the films to disintegrate or dissolve in water at 10°C.

**Table 2**

| | PVOH | PVOH/starch | PVOH/starch |
|---|---|---|---|
| Gauge/µm | 30.0 | 23.9 | 69.0 |
| Maximum stress (MD) /MPa | 50 | 14.61 | 14.80 |
| Maximum stress (TD)/MPa | 35 | 13.10 | 14.27 |
| Extension at break (mud)/% | 200 | 307 | 363 |
| Extension at break (TD) /% | 350 | 308 | 363 |
| Elastic modulus (MD)/MPa | 30 | 4.4 | 3.4 |
| Elastic modulus (TD)/MPa | 5 | 3.6 | 3.3 |
| Disintegration time/s | 10 | 1 | 14 |
| Dissolution time/s | 45 | 128 | 420 |

Referring now to Table 3, measurements are shown for films of a conventional PVOH film and those made from mixtures of PVOH and starch; in this case the PVOH is a grade that would be soluble in warm water at 60°C. It should be-noted that the films embodying the invention were of different thickness. The mechanical properties (of dry film) are tabulated in both the machine direction (MD), which is the longitudinally direction of the extrusion, and in the transverse direction (TD). The disintegration and dissolution times are the times taken for the films to disintegrate or dissolve in water at 63°C.

**Table 3**

| | PVOH | PVOH/50 % starch | PVOH/25 % starch | PVOH/33 % starch |
|---|---|---|---|---|
| Gauge/µm | 25.6 | 18.9 | 50.8 | 24.9 |
| Max. stress (MD)/MPa | 74.40 | 30.96 | 40.00 | 44.35 |
| Max. stress (TD)/MPa | 50.60 | 29.60 | 35.73 | 46.92 |
| Extension at break (MD) /% | 169 | 130 | 222 | 166 |
| Extension at break (TD) / % | 304 | 219 | 274 | 261 |
| Elastic modulus (MD) /MPa | 121 | 50 | 50 | 61 |
| Elastic modulus (TD) /MPa | 49 | 22 | 32 | 27 |
| Disintegration time/s | 1.33 | 1 | 2.66 | 2 |
| Dissolution time/s | 38.7 | 127 | 302 | 152 |

In a first embodiment of the invention, filmic substrates of thickness between 20 and 100 microns made by the process described above can be converted into bags for use in the packaging of electronic components which are sensitive to static electricity. It is a preferred feature of these bags that they are made from the inventive composition throughout including any closure mechanism, for example Kwik Lok®, Zip-pak®, Velcro® or self-adhesive fastenings. The bags may of course be closed by heat sealing.

In a second embodiment, filmic substrates of thickness between 80 and 300 microns made by the process described above can be converted by thermoforming into blister packs and clam shell packs offering electrostatic dissipative properties. Such articles can be formed by thermoforming or vacuum forming or a combination thereof from extrusion cast sheet or extrusion blown sheet.

In a third embodiment of the invention, profiles and preferably tubular profiles (such as IC tubes), are extruded, which may be used as biodegradable packages for packaging e.g. integrated circuits in both single and dual in-line tubes. The current method of providing a static dissipative tubular package is to extrude a PVC profile and then apply an antistatic coating to both the inside and the outside of the profile. This has disadvantages in that the coating may not be continuous and may be damaged in use by for example the movement of the packed components within the tube, and in addition, the profile is not compostable and biodegradable. Using material embodying the invention, profiles and end plugs may be made which are inherently static dissipative and compostable and biodegradable, therefore proving advantageous in many applications.

Accordingly, tubing designed to contain a range of integrated circuits including standard SIL or DIL packages in 0.3" or 0.6" pitch, surface mount devices and all ranges of semiconductor packages mapped on standard tube profiles recognised through the electronics industry may be provided. The tubes may range in length from, for example, 20mm to 600mm.

In addition, moulded packages designed to accommodate quad or DIL surface mount integrated circuit packages in a well of the package, so as to provide mechanical protection as well as static dissipative properties, may be provided.

In accordance with a fourth embodiment of the invention, we have found that it is possible to extrude fibres that can be used in the manufacture of woven or non-woven garments. By this means, it is possible to manufacture garments and mats for use at entrances to and exits from electrostatic discharge (ESD) sensitive areas that are both static dissipative and compostable and biodegradable.

In a fifth embodiment, further additives are added to the inventive composition in order to obtain shielding properties whereby the contents of the package are not affected by electric fields that the package may pass through during for example transport from the manufacturer to the customer. These additives will have electrically conductive properties in order to improve the shielding characteristics of the package. Typically, the additives will include carbon-based powder and fibres, metal powder and fibres, and metal-coated fibres of carbon and glass. Varying the percentage or type of conductive additive used in the package permits variation in the degree of shielding obtained.

As will now be understood, the present invention provides novel packages and personal protection items which are inherently electro-statically dissipative, compostable and biodegradable and, in comparison with current conventional electrostatic dissipative products, with an enhanced response to changes in relative humidity between 20% and 80%.

## Claims

1. An electrostatically dissipative package for containing an article sensitive to static electricity, the package substantially comprising a non-expanded polymeric material which has electrostatic dissipative properties, wherein said polymeric material comprises a mixture of polyvinyl alcohol (PVOH) and thermo-plastically processable starch.

2. A package according to Claim 1, wherein at least a portion of the polymeric material is a film.

3. A package according to Claim 2, wherein the package is a bag.

4. A package according to claim 3, wherein the bag has a closure mechanism comprising the polymeric material.

5. A package according to Claim 1, wherein the package is a clam-shell, blister pack or IC tube.

6. A package according to any preceding Claim, wherein the non-expanded polymeric material comprises the entire package.

7. A package according to any preceding Claim, wherein the material comprises at least 10% of starch by weight.

8. A package according to Claim 7, wherein the material comprises at least 25% of starch by weight.

9. A package according to any preceding Claim, wherein the material comprises at least 10% of PVOH by weight.

10. A package according to Claim 9, wherein the material comprises at least 20% of PVOH by weight.

11. A package according to Claim 10, wherein the material comprises at least 25% of PVOH by weight.

12. A package according to Claim 11; wherein the material comprises at least 40% of PVOH by weight.

13. A package according to any of Claims 1 to 12, wherein the material comprises substantially equal quantities of starch and PVOH.

14. A package according to any preceding Claim, further comprising one or more additives which provide the package with electromagnetic shielding properties.

15. Use of a non-expanded polymeric material to produce an electrostatically dissipative package for containing an article sensitive to static electricity, the material including a mixture of thermo-plastically processable starch (TPS) and polyvinyl alcohol (PVOH).

16. A fabric article having electrostatic dissipative properties, comprising fibres of a polymeric material, the material comprising a mixture of thermo-plastically processable starch (TPS) and polyvinyl alcohol (PVOH).

17. A package according to any of claims 1-14, packaging an article sensitive to static electricity.

18. A method of forming an electrostatically dissipative package for an article sensitive to static electricity, the method comprising forming the package substantially from a non-expanded polymeric material which has electrostatic dissipative properties, wherein said polymeric material comprises a mixture of polyvinyl alcohol (PVOH) and thermoplastically processable starch.

## Patentansprüche

1. Elektrostatisch ableitfähige Verpackung zum Aufnehmen eines Gegenstandes, der gegenüber statischer Elektrizität empfindlich ist, wobei die Verpackung im Wesentlichen ein nicht geschäumtes Polymermaterial umfasst, das elektrostatisch ableitfähige Eigenschaften hat und es ein Gemisch aus Polyvinylalkohol (PVOH) und thermoplastisch verarbeitbarer Stärke umfasst.

2. Verpackung nach Anspruch 1, wobei zumindest ein Teil des Polymermaterials ein Film ist.

3. Verpackung nach Anspruch 2, wobei die Verpackung ein Beutel ist.

4. Verpackung nach Anspruch 3, wobei der Beutel einen Verschlussmechanismus umfasst, der das Polymermaterial umfasst.

5. Verpackung nach Anspruch 1, wobei die Verpackung zweischalig, eine Blister-Verpackung oder ein IC-Rohr ist.

6. Verpackung nach einem vorhergehenden Anspruch, wobei das nicht geschäumte Polymermaterial die gesamte Verpackung umfasst.

7. Verpackung nach einem vorhergehenden Anspruch, wobei das Material mindestens 10 Gewichtsprozent Stärke umfasst.

8. Verpackung nach Anspruch 7, wobei das Material mindestens 25 Gewichtsprozent Stärke umfasst.

9. Verpackung nach einem vorhergehenden Anspruch, wobei das Material mindestens 10 Gewichtsprozent PVOH umfasst.

10. Verpackung nach Anspruch 9, wobei das Material mindestens 20 Gewichtsprozent PVOH umfasst.

11. Verpackung nach Anspruch 10, wobei das Material mindestens 25 Gewichtsprozent PVOH umfasst.

12. Verpackung nach Anspruch 11, wobei das Material mindestens 40 Gewichtsprozent PVOH umfasst.

13. Verpackung nach einem der Ansprüche 1 bis 12, wobei das Material im Wesentlichen gleiche Mengen Stärke und PVOH umfasst.

14. Verpackung nach einem vorhergehenden Anspruch, zudem umfassend ein oder mehrere Additive, die der Verpackung elektromagnetische Abschirmeigenschaften verleihen.

15. Verwendung eines nicht geschäumten Polymermaterials zur Herstellung einer elektrostatisch ableitfähigen Verpackung zur Aufnahme eines Gegenstandes, der gegenüber statischer Elektrizität empfindlich ist, wobei das Material ein Gemisch von thermoplastisch verarbeitbarer Stärke (TPS) und Polyvinylalkohol (PVOH) umfasst.

16. Gewebegegenstand mit elektrostatisch ableitfähigen Eigenschaften, der Fasern eines Polymermaterials umfasst, wobei das Material ein Gemisch aus thermoplastisch verarbeitbarer Stärke (TPS) und Polyvinylalkohol (PVOH) umfasst.

17. Verpackung nach einem der Ansprüche 1 bis 14 zum Verpacken eines Gegenstandes, der gegenüber statischer Elektrizität empfindlich ist.

18. Verfahren zur Herstellung einer elektrostatisch ableitfähigen Verpackung für einen Gegenstand, der gegenüber statischer Elektrizität empfindlich ist, wobei bei dem Verfahren die Verpackung im Wesentlichen aus einem nicht geschäumten Polymermaterial mit elektrostatisch ableitfähigen Eigenschaften gebildet wird, und wobei das Polymermaterial ein Gemisch aus Polyvinylalkohol (PVOH) und thermoplastisch verarbeitbarer Stärke umfasst.

## Revendications

1. Conditionnement à dissipation électrostatique pour contenir un article sensible à l'électricité statique, le conditionnement comprend essentiellement un matériau polymère non expansé possédant des propriétés de dissipation électrostatique, dans lequel ledit matériau polymère comprend un mélange de poly(alcool vinylique) (PVOH) et d'amidon transformable de manière thermoplastique.

2. Conditionnement selon la revendication 1, dans lequel au moins une partie du matériau polymère est un film.

3. Conditionnement selon la revendication 2, dans lequel le conditionnement est un sac.

4. Conditionnement selon la revendication 3, dans lequel le sac possède un mécanisme de fermeture comprenant le matériau polymère.

5. Conditionnement selon la revendication 1, dans lequel le conditionnement est un emballage double coque, un emballage-coque ou un tube IC.

6. Conditionnement selon l'une quelconque des revendications précédentes, dans lequel le matériau polymère non expansé compose la totalité du conditionnement.

7. Conditionnement selon l'une quelconque des revendications précédentes, dans lequel le matériau comprend au moins 10 % d'amidon en poids.

8. Conditionnement selon la revendication 7, dans lequel le matériau comprend au moins 25 % d'amidon en poids.

9. Conditionnement selon l'une quelconque des revendications précédentes, dans lequel le matériau comprend au moins 10 % de PVOH en poids.

10. Conditionnement selon la revendication 9, dans lequel le matériau comprend au moins 20 % de PVOH en poids.

11. Conditionnement selon la revendication 10, dans lequel le matériau comprend au moins 25 % de PVOH en poids.

12. Conditionnement selon la revendication 11, dans lequel le matériau comprend au moins 40 % de PVOH en poids.

13. Conditionnement selon les revendications 1 à 12, dans lequel le matériau comprend des quantités sensiblement égales d'amidon et de PVOH.

14. Conditionnement selon l'une quelconque des revendications précédentes, comprenant en outre un ou plusieurs additifs conférant au conditionnement des propriétés de protection contre les rayonnements électromagnétiques.

15. Utilisation d'un matériau polymère non expansé pour produire un conditionnement à dissipation électrostatique pour contenir un article sensible à l'électricité statique, le matériau comprend un mélange d'amidon transformable de manière thermoplastique (TPS) et de poly(alcool vinylique) (PVOH).

16. Article textile possédant des propriétés de dissipation électrostatique, comprenant des fibres de matériau polymère, le matériau comprenant un mélange d'amidon transformable de manière thermoplastique (TPS) et de poly (alcool vinylique) (PVOH).

17. Conditionnement selon l'une quelconque des revendications 1 à 14, conditionnant un article sensible à l'électricité statique.

18. Procédé de formation d'un conditionnement à dissipation électrostatique pour un article sensible à l'électricité statique, le procédé comprenant la formation du conditionnement essentiellement à partir d'un matériau polymère non expansé possédant des propriétés de dissipation électrostatique, dans lequel ledit matériau polymère comprend un mélange de poly(alcool vinylique) (PVOH) et d'amidon transformable de manière thermoplastique.
